# FASCICULE DE BREVET EUROPEEN

(11) **EP 0 800 676 B1**
(45) Date de publication et mention de la délivrance du brevet: **19.08.1998**
(21) Numéro de dépôt: 95943251.9
(22) Date de dépôt: 20.12.1995
(51) Int. Cl.: G06F 11/273

(54) **PROCEDE ET EQUIPEMENT DE TEST AUTOMATIQUE DE COMPOSANTS ELECTRONIQUES**
VERFAHREN UND EINRICHTUNG ZUM AUTOMATISCHEN PRÜFEN ELEKTRONISCHER BAUTEILE
METHOD AND EQUIPMENT FOR THE AUTOMATIC TESTING OF ELECTRONIC COMPONENTS

(30) Priorité: 23.12.1994 FR 9415559
(43) Date de publication de la demande: 15.10.1997
(73) Titulaire: SCHLUMBERGER INDUSTRIES S.A., 92120 Montrouge (FR)
(72) Inventeur: FOURNEL, Jean-Claude, F-43140 Saint-Victor-Malescours (FR); DEVUN, Thierry, F-42330 Saint-Bonnet-les-Oules (FR); DUMAS, Jean-Pierre, F-42100 Saint-Etienne (FR)
(74) Mandataire: Lemoyne, Didier
(86) Numéro de dépôt international: FR9501704
(87) Numéro de publication internationale: WO9620444

(56) Documents cités:
- US-A- 5 025 205
- PROCEEDINGS INTERNATIONAL TEST CONFERENCE 1993, 1 Janvier 1993, pages 226-235, XP000437136 D. J. MIRIZZI ET AL.: "Implementation of parallelsite test on an 8-bit configurable microcontroller"
- ELECTRONICS, vol. 59, no. 20, Mai 1986, NEW YORK US, pages 49-52, XP002000464 "How GENRAD's new tester copes with VHSIC chips"
- PATENT ABSTRACTS OF JAPAN vol. 007, no. 241 (P-232) 26 Octobre 1983 & JP,A,58 129274 (TOKYO SHIBAURA DENKI KK) 2 Août 1983
- PATENT ABSTRACTS OF JAPAN vol. 008, no. 129 (P-280) 15 Juin 1984 & JP,A,59 032876 (TOKYO SHIBAURA DENKI KK) 22 Février 1984

## Description

La présente invention est relative aux procédés et aux équipements de test automatiques de composants électroniques contenant des parties numériques séquentielles et plus particulièrement, aux équipements de test permettant de tester plusieurs de ces composants en parallèle.

La plupart des circuits numériques commercialisés sont testés par leur fabricant plusieurs fois avant d'être expédiés. Les testeurs de composants ont pour mission de générer des signaux numériques (état logique "0" ou "1") ainsi que de vérifier la présence de transitions en sortie du circuit sous test. Les signaux générés et les signaux "comparés" sont programmables en temps ainsi qu'en niveaux. Un testeur de composants doit générer et/ou comparer des signaux sur toutes les broches fonctionnelles du composant sous test simultanément.

La définition des signaux à générer et/ou comparer est généralement extrêmement complexe. Le test d'un microprocesseur peut entraîner des chaînes de plusieurs millions de zéros et de uns dans une même séquence. Pour définir ces signaux, on utilise la notion de période, qui définit une tranche de temps à l'intérieur de laquelle un signal plus simple est décrit. Ce signal se décompose en une information de temps (appelée aussi marqueur de temps) et en un événement (par exemple une transition ou un test).

L'exécution d'un test fonctionnel se traduit ainsi par le déroulement d'une mémoire dont chaque ligne correspond à une période et dont le contenu représente l'information des temps et événements définissant le signal à l'intérieur de la période pour chaque broche. Aux informations de temps et événements s'ajoute, entre autre, une instruction destinée à gérer le déroulement de cette mémoire. Cette instruction est commune pour l'ensemble des broches fonctionnelles du circuit sous test. L'instruction la plus courante est celle qui consiste à aller lire la ligne suivante (instruction INC). Cette mémoire est appelée mémoire principale ("main" en anglais). On utilise aussi des mémoires sous-programme ("sub-memory" en anglais).

Cette architecture, basée sur le déroulement de mémoires, est déterministe. C'est-à-dire qu'elle suppose qu'il est possible, a priori, de savoir exactement ce qui va se passer à un instant donné sur les broches de sortie du circuit sous test.

Il existe des composants numériques (microprocesseurs par exemple) dont l'état logique interne ne peut être connu a priori. Par conséquent, les signaux de test ne peuvent être connus a priori. Pour tester ce type de composant, il faut pouvoir amener celui-ci à un état connu. Pour cela, il faut pouvoir générer des signaux (signaux d'horloge par exemple) jusqu'à l'apparition d'un événement ou d'une suite d'événements prédéterminés sur une ou plusieurs sorties du circuit sous test. Pour gérer, dans ces conditions, le déroulement de la mémoire principale ou sous-programme, il existe des instructions adaptées qui consistent à boucler la mémoire tant qu'une condition particulière ne s'est pas produite. La méthode qui consiste à attendre qu'un circuit se mette dans un état prédéterminé est appelée "mise en phase" ("match" en anglais). L'exemple le plus simple est de considérer un diviseur dont on ne connaît pas l'état initial. Des signaux d'horloge générés en entrée de ce diviseur provoquent une transition une fois tous les n fronts d'horloge. Pour synchroniser ce type de composant, il faut générer des signaux d'horloge jusqu'à l'apparition d'une transition de sortie. Lorsque cette transition apparaît, le diviseur est dans un état connu et la suite du test se fait de façon déterministe. Lorsque le composant sous test est mauvais, il se peut que la condition de sortie de la séquence de mise en phase ne soit jamais trouvée. Un nombre maximum de boucles doit être initialement programmé pour éviter de boucler indéfiniment. Par exemple, dans le cas du diviseur par n, on doit trouver la transition de sortie en moins de n+1 fronts d'horloge. Dans ce cas, après n+1 fronts, la séquence de mise en phase s'arrête et celle ci est jugée mauvaise. Dans certains cas complexe, le temps nécessaire avant de juger une séquence de mise en phase mauvaise peut être assez important.

L'architecture d'un testeur contient une partie génération/réception de signaux numériques et une partie mise en forme de ces signaux. La partie mise en forme constitue la plupart du temps la tête de mesure tandis que la partie génération/réception peut se situer dans une baie séparée.

Afin d'optimiser le coût du test, il est possible de connecter plusieurs têtes à la partie génération/réception de signaux. Généralement des multiplexeurs (1 par signal et par broche) placés en sortie de la partie génération/réception permettent d'aiguiller les signaux sur une tête ou sur l'autre. Ainsi, un composant est testé sur la tête n°1 pendant qu'un autre composant est manipulé sur la tête n°2, puis l'inverse. Cela permet d'augmenter la capacité du testeur en ajoutant une tête. Typiquement, si le temps de test est identique au temps de manipulation, l'adjonction d'une tête permet de doubler la capacité du testeur. Les circuits testés sur les deux têtes sont obligatoirement identiques.

Comme les signaux générés sont identiques sur les deux têtes et que les signaux comparés doivent également être similaires, l'idée est venue de proposer des testeurs à deux têtes simultanées. Les signaux générés sont envoyés en parallèle sur les deux têtes. Les signaux reçus sont comparés à une table simultanément par des circuits différents. Le testeur gère alors deux résultats : celui venant de la tête 1 et celui venant de la tête 2. Ainsi, en doublant simplement le circuit de comparaison des signaux reçus à une table (sachant que la table est la même pour la tête 1 que pour la tête 2 puisque les signaux générés et les composants à tester sont identiques), on double réellement la capacité du testeur.

Le test en parallèle permet de tester n composants simultanément de façon similaire au test d'un seul composant. L'ensemble des ressources destinées au test d'un composant est appelé site. Le test simultané peut se faire sur une même tête ou bien sur plusieurs têtes. La présente invention adresse les deux cas.
Lorsque plusieurs composants sont testés en parallèle, la mise en phase implique d'amener tous les composants à un état connu et identique. Lorsque la condition attendue apparaît sur le premier composant, l'état de tous les autres composants peut être quelconque. Il faut donc synchroniser un premier composant puis passer au suivant tout en maintenant le premier composant dans un état connu et ainsi de suite.

Les testeurs de composants classiques présentent un inconvénient grave qui est que lorsqu'un défaut est détecté pendant une séquence fonctionnelle, on arrête la séquence et, généralement, on passe au composant suivant. Un objet de la présente invention est de fournir un procédé et un équipement de test en parallèle selon lesquels on continue de tester les composants bons en ignorant le ou les mise(s) en phase des composants mauvais de façon à éviter de consacrer un temps qui peut être long à essayer de synchroniser un composant mauvais.

Par ailleurs, un test destiné à n composants en parallèle doit pouvoir se faire sur un nombre plus petit de composants. Selon la présente invention, les séquences de mise en phase d'un composant mauvais ou d'un site non utilisé sont automatiquement ignorées de façon à ne pas pénaliser le temps de test. Par exemple, lors du test sur tranche de silicium, lorsque la carte à pointes arrive en extrémité de tranche, il se peut que des sites soient en dehors de la zone diffusée et qu'on ait des aiguilles de test qui ne reposent sur aucun composant. Dans ce cas, un testeur selon la présente invention ignore les mises en phase pour ces composants.

Les séquences de mise en phase peuvent être ignorées a priori si le site correspondant est dévalisé ou si un autre test a déjà jugé le composant mauvais.
Les séquences de mise en phase peuvent aussi être ignorées à la volée si l'une d'entre elles n'aboutit pas.

De façon plus précise, la présente invention se rapporte à un procédé de test en parallèle de composants électroniques en utilisant des instructions contenues dans une mémoire principale ou sous programme, chaque instruction contenant les informations relatives au test à effectuer sur les sites à tester en parallèle, après mise en phase des composants selon une séquence de mise en phase destinée à amener chaque composant dans un état connu et identique. ledit procédé étant caractérisé par les étapes suivantes, permettant d'éliminer les séquences de mise en phase d'un composant lorsque l'une d'entre elles n'a pas abouti tout en autorisant les mises en phase du ou des autres composants :
- l'adresse du site en cours de test est enregistrée dans un compteur,
- des informations de validation selon lesquelles la séquence de mise en phase d'un site doit être effectuée ou ignorée sont contenues dans une mémoire de validation adressée par ledit compteur et,
- lesdites informations de validation sont soit écrites préalablement à la séquence de test de façon à effectuer la séquence de mise en phase du site en cas de validation ou à ignorer celle ci en passant à l'instruction suivante dans la mémoire principale.

Les dites informations de validations peuvent être modifiées a la volée si une séquence de mise en phase s'avère mauvaise de façon a dévalider les mises en phase future qui pourraient avoir lieu pour le site dans une même séquence.

Ladite mémoire est relue a la fin de la séquence et permet d'identifier les séquences de mise en phase qui ont échouées.

Selon une caractéristique du procédé de l'invention, ladite mémoire de validation est donc programmée a priori et/ou en cours de test.

L'invention se rapporte également à un équipement automatique de test de composants électroniques dans lequel des composants sont testés en parallèle à l'aide d'au moins une tête de test, comprenant :
- une mémoire principale. des instructions à exécuter pour le test et une table contenant des données à comparer aux données résultant des tests.
- des circuits élémentaires de test, chacun d'eux étant affecté à une broche de connexion et reliés aux entrées et sorties de la ou desdites têtes de test, l'entrée des circuits élémentaires étant reliée à la sortie de la mémoire principale,
- un circuit de mise en phase pour comparer les données de test à des données prédéterminées afin d'amener chaque composant dans un état connu et identique selon une séquence de mise en phase, ce circuit étant connecté aux sorties desdits circuits élémentaires de test,
   l'équipement de test étant caractérisé, pour permettre d'éliminer les séquences de mise en phase d'un composant lorsque l'une d'entre elles n'a pas abouti tout en autorisant les mises en phase du ou des autres composants, par :
- un compteur qui détermine les sites à mettre en phase et qui possède une entrée d'incrémentation connectée à une sortie dudit circuit de mise en phase et,
- une mémoire de validation adressée par ledit compteur et qui définit si chacun desdits sites doit être mis en phase ou ignoré.

La mémoire de validation du circuit de mise en phase comporte une sortie de validation qui transforme l'instruction de gestion de la mémoire principale de façon a passer a la ligne suivante (INC) si la séquence de mise en phase doit être ignorée.

L'équipement de test comporte avantageusement un circuit de multiplexage permettant la programmation a priori de la mémoire de validation du circuit de mise en phase ou la programmation à la volée.

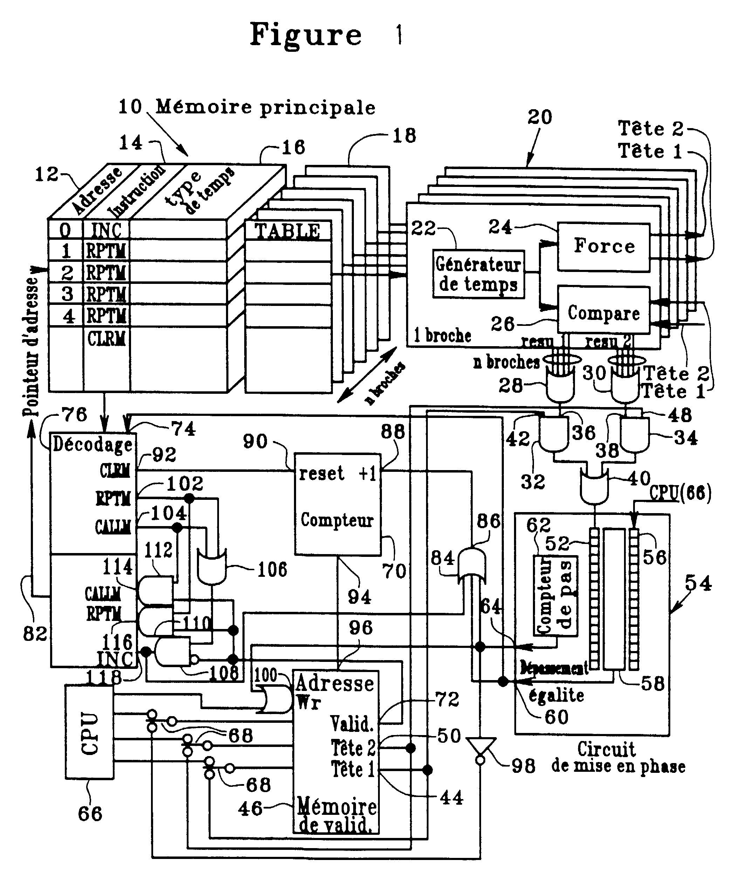

L'invention sera mieux comprise à la lecture de la description qui suit d'un mode de réalisation de l'invention donné à titre indicatif mais nullement limitatif. La description se réfère au dessin qui l'accompagne, la figure unique montrant schématiquement la partie de l'équipement de test conforme à l'invention.

La gestion de la synchronisation fonctionnelle de composants sur un testeur parallèle selon l'invention implique une architecture particulière permettant de définir a priori ou à la volée les sites à synchroniser. Cette architecture comprend un compteur qui définit le numéro du site en cours de synchronisation et une mémoire de validation du circuit de mise en phase programmable par bus (programmation a priori) ou à la volée (à la fin d'une séquence de mise en phase) adressée par le compteur ci-dessus, indiquant si la mise en phase du site correspondant doit être ignoré ou pas. Le mode de réalisation expliqué ci-après inclut le test en parallèle et simultané sur deux têtes. L'invention s'applique également aux équipements de test à une tête utilisés pour tester plusieurs composants en parallèle.

Sur la figure unique, la mémoire principale 10 contient les instructions nécessaires au déroulement de la séquence fonctionnelle de test.

La mémoire principale est généralement volumineuse (plusieurs millions d'opérations élémentaires de tests appelées "vecteurs"). Pour des raisons de coût ainsi que de volume, on utilise des mémoires lentes associées à une électronique permettant de générer rapidement des vecteurs à partir de plusieurs mémoires lentes en parallèle. Cette électronique ne permet pas de sauts (donc de boucles) à l'intérieur de cette mémoire. Lorsque le test d'un circuit numérique nécessite l'utilisation de boucles, ou bien lorsque certains morceaux de séquences doivent se répéter plusieurs fois à l'intérieur d'un même test fonctionnel, on utilise une mémoire sous programme ("Sub"), plus petite en taille mais dont le jeu d'instructions est plus complet. Il existe une instruction de la mémoire principale permettant d'aller à la mémoire sous programme. A la fin de l'exécution d'un sous-programme, on revient dans la mémoire principale.

Chaque adresse 12 de la mémoire principale définit entre autre :
- une instruction 14 qui est commune à l'ensemble des broches sous test et qui gère le déroulement de la mémoire principale. On nomme CALLM et RPTM des instructions d'appel de la séquence de mise en phase. Lorsque ces instructions sont invoquées, le circuit de mise en phase est activé et gère ainsi le déroulement de la mémoire (principale ou de sous-programme). L'instruction RPTM ("repeat match") exécute la même ligne jusqu'à ce que la mise en phase soit trouvée. L'instruction CALLM ("call match") exécute une série d'instructions jusqu'à ce que la mise en phase soit trouvée. L'instruction CALLM boucle ainsi la mémoire. L'instruction INC consiste simplement à passer à la ligne suivante.
- la définition du type de temps 16 à utiliser pendant l'exécution de cette adresse de la mémoire. Le type de temps est commun pour l'ensemble des broches du testeur et correspond à l'adresse d'une mémoire qui est par broche et dans laquelle est définie la valeur des temps correspondant à cette adresse. Cette architecture de définition des temps correspond à l'architecture dite "séquenceur par broche" qui fait l'objet du brevet US n°5,212,443.
- une table 18 qui correspond au contenu logique (0 ou 1) des signaux à envoyer ou à comparer. Cette table est par broche.

Le testeur reçoit du composant sous test des signaux qu'il compare aux données de la table 18. Un signal reçu peut être testé ou ignoré. Pendant une période de test (tranche de temps élémentaire d'une séquence de test), chaque broche dont on reçoit un signal peut être conforme à la table, non conforme ou ignorée. L'ensemble des broches non ignorées permet de définir si on est conforme ou pas à la table ("ou" logique sur toutes les broches générant un signal testé). Puis on définit une suite de conditions (conforme ou non conforme). Lorsque cette liste de conditions est remplie, on dit que la mise en phase ("match") est trouvée. Une mise en phase inclut toujours un nombre maximum de périodes au delà duquel la mise en phase est déclarée non trouvée. L'opération de mise en phase ("match") est un moyen d'amener un composant à un état connu. Elle consiste à exécuter une séquence d'opérations élémentaires, jusqu'à ce qu'une série d'événements se produise en sortie du circuit sous test. Lorsque cette séquence a lieu, on dit que la mise en phase est trouvée. Le composant est alors dans un état connu.

La mémoire principale permet de définir le signal à générer pour chaque broche. Ainsi, on définit une fonction élémentaire de génération ou de comparaison de signaux, identique pour chaque broche, qui, à partir des informations de la mémoire principale 10, génère les stimuli et reçoit des signaux à comparer.

Ceci est réalisé à l'aide de circuits élémentaires de test identiques 20, chaque circuit étant affecté à une broche et comprenant un générateur de temps 22 contrôlant en parallèle un générateur d'événements de force 24 envoyant des signaux de test aux deux têtes 1 et 2 (par exemple, on "force" une broche du composant de 0 à 5 Volt) et un circuit de comparaison 26 recevant des signaux de test des têtes 1 et 2 et comparant ces signaux avec les données figurant dans la table 18.

Le générateur de temps 22 définit les instants auxquels il faut générer des fronts de signaux, les instants où il faut commencer la comparaison à la table 18 et les instants où il faut cesser de comparer. Lorsque le circuit de comparaison 26 doit effectuer une comparaison, il génère un résultat (conforme ou non conforme à la table). Ce résultat est propre à chaque broche et à chaque tête sur lesquelles sont effectuées des comparaisons. Sur la figure, ce résultat est indiqué par un "resu 1" pour la tête 1 et par un "resu 2" pour la tête 2. En faisant un "OU" logique sur l'ensemble des broches du testeur, à l'aide des portes OU 28 et 30, respectivement pour la tête 1 et la tête 2, il est possible de savoir si l'ensemble est conforme ou non à la table.

La sortie des portes OU 28 et 30 est connectée respectivement aux entrées 36 et 38 des portes ET 32 et 34. Les sorties des portes ET 32 et 34 sont connectées aux deux entrées d'une porte OU 40. La deuxième entrée 42 de la porte ET 32 est connectée à la sortie 44 d'une mémoire de validation de séquence de mise en phase 46. Cette sortie 44 correspond à la tête numéro 1. De façon symétrique, la deuxième sortie 48 de la porte ET 34 est connectée à la sortie 50 de la mémoire de validation 46. Cette sortie 50 correspond à la tête numéro 2.

La logique définie par les deux portes ET 32 et 34 et la porte OU 40 permet de définir un signal qui, à chaque pas de test (période), vaut 0 ou 1. Ce signal vaut 0 lorsque le test du composant se révèle conforme à la table et que la tête 1 ou 2 correspondante est validée à l'aide de la mémoire de validation 46. La sortie de la porte OU 40 est au niveau logique 1 si le composant testé s'est révélé non conforme à la table et si la tête 1 ou 2 correspondant aux portes ET 32 ou 34 est validée. En effet, les sorties des portes OU 28 et 30 sont à un niveau logique 0 si les composants testés par les têtes 1 et 2 sont conformes à la table. Par contre si l'un des composants se révèle non conforme à la table, par exemple celui testé à l'aide de la tête 1, la sortie de la porte OU 28 sera à un niveau logique 1.

Le signal en sortie de la porte OU 40 est injecté dans un registre à décalage 52 d'un circuit de mise en phase 54. Ce registre à décalage avance à chaque période. A chaque période le contenu du registre à décalage 52 est comparé au contenu d'un registre 56 qui a été préalablement programmé à l'aide du processeur (CPU) de l'équipement de test. Ce registre 56 est initialisé au début de la séquence de test. Un comparateur numérique 58 génère un signal à un niveau logique 1 lorsque le registre à décalage 52 possède le même contenu que le registre 56 programmé par le processeur (CPU) en début de séquence. La sortie "égalité" 60 du circuit de mise en phase 58 est au niveau logique 0 lorsqu'il n'y a pas équivalence entre le contenu des registres 52 et 56. Un compteur de pas 62 génère un signal de niveau logique 1 à la sortie "dépassement" 64 lorsque la mise en phase n'est pas trouvée après un nombre de périodes prédéterminées (signal de dépassement).
La mémoire de validation du circuit de mise en phase 46 permet de valider ou non un état de mise en phase sur chacune des têtes 1 et 2 à l'aide des portes ET 32, 34 et de la porte OU 40. Cette mémoire 46 peut être programmée par un registre (CPU) 66 de l'équipement de test (programmation a priori) en fonction d'informations que l'on possède déjà sur le composant (site non utilisé ou composant jugé mauvais dans un test précédent) ou à la volée, c'est-à-dire en cours de séquence, en fonction de la position du multiplexeur 68. Les adresses de la mémoire sont déterminées par un compteur d'adresse 70. La mémoire 46 comporte 3 bits par adresse, un pour définir si la mise en phase est valide ou pas (bit 0), un pour valider ou pas la tête 1 (bit 2) et un pour valider ou pas la tête 2 (bit 1). La mémoire comporte 256 lignes. Son contenu est donc 256 x 3 bits, alors que le compteur 70 est à 8 bits (8 bits suffisent en effet pour définir les 256 adresses de la mémoire de validation). Les 3 bits par adresse de la mémoire de validation correspondent aux trois sorties 44 pour la tête 1, 50 pour la tête 2 et 72 pour la sortie "valid".

La sortie "égalité" 60 du circuit de mise en phase est reliée à l'entrée 74 du circuit de décodage 76 des instructions de déroulement de la mémoire (principale ou sous programme). Ce circuit interprète lesdites instructions pour gérer la valeur du pointeur d'adresse 82 de la mémoire principale par exemple. Lorsqu'une instruction 14 d'appel à une séquence de mise en phase est invoquée, le circuit de décodage 76 attend que la mise en phase soit trouvée (sortie 60 du circuit de mise en phase connectée a l'entrée 74 du circuit de décodage d'instruction) pour incrémenter le pointeur d'adresse de la mémoire principale.
La sortie "égalité" 60 est également connectée à l'une des trois entrées d'une porte OU 84 dont la sortie 86 est connectée à l'entrée "+1" 88 du compteur d'adresse 70. L'entrée "reset" 90 du compteur d'adresse est reliée à la sortie 92 CLRM du circuit de décodage 76. La sortie 94 du compteur 70 est reliée à l'entrée "adresse" 96 de la mémoire de validation.

La sortie "dépassement" 64 est reliée à l'une des entrées de la porte OU 84, à l'entrée du multiplexeur 68 par l'intermédiaire d'un inverseur 98 et enfin à l'une des deux entrées d'une porte OU 100. L'autre entrée de cette porte 100 est reliée au registre (CPU) 66. La sortie de la porte 100 reliée à l'entrée écriture Wr de la mémoire de validation 46.

Lorsque le circuit de décodage 76 décode une instruction d'appel à une séquence de mise en phase, les signaux (RPTM) à la sortie 102 ou (CALLM) à la sortie 104 sont activés. Les portes logiques 106, 108, 110 et 112 permettent de transformer ou non ces instructions en l'instruction INC. En effet, si la mémoire de validation 46 à sa sortie valid 72 à 1, les signaux 114 (CALLM) et 116 (RPTM) sont identiques aux signaux 104 (CALLM) et 102 (RPTM). De ce fait, la séquence de mise en phase est effectuée et le circuit de décodage attend que l'égalité (entrée 74) soit trouvée pour incrémenter le pointeur d'adresse 82 de la mémoire principale 10.
Si la sortie valid 72 vaut 0, les sorties des portes ET 110 et 112 sont a 0 et la sortie de la porte 108 est activée. Dans ce cas, c'est le signal INC 118 qui vaut 1 et le circuit de décodage considère l'instruction INC au lieu de l'instruction d'appel à la séquence de mise en phase.

Les sorties 44 tête 1 et 50 tête 2 de la mémoire de validation 46 sont utilisées pour sélectionner la tête 1 ou la tête 2 ou les deux têtes pour l'opération d'équivalence effectuée dans le circuit d'équivalence 54, en agissant sur les portes ET 32 et 34.

De façon simplifiée, le fonctionnement du circuit est le suivant. Le compteur 70 est initialisé à 0 en début de séquence fonctionnelle. Il détermine le numéro du site sur lequel la mise en phase doit se faire. Ce compteur adresse la mémoire qui définit si le site doit être ignoré (sortie valid = 0) ou pris en compte (sortie valid = 1), et sur quelle tête il se fait (sortie tête 1 ou tête 2). En effet, la comparaison d'un signal généré par une broche sous test génère un résultat propre à chaque tête (resu 1, resu 2). Dans la majeure partie des cas, la mise en phase se fait sur une tête puis l'autre. Ainsi, le circuit de mise en phase prend en compte un seul résultat à la fois. Dans certains cas, on peut imaginer, pour gagner du temps, d'exécuter les misés en phase sur les deux têtes en parallèle. Dans ce cas, le circuit de mise en phase reçoit un résultat qui est une combinaison logique des résultats des deux têtes. Il faut donc s'assurer, que le déroulement de la séquence permet dans tous les cas de synchroniser les deux circuits en une seule opération de mise en phase.

Selon l'invention, les instructions CALLM et RPTM sont transformées en instructions INC lorsqu'il faut ignorer la mise en phase d'un site. Si la sortie valid 72 de la mémoire est à 0 (ignorer le site), les instructions CALLM et RPTM sont transformées en INC.

Si la mise en phase n'est pas trouvée, le bit correspondant à ce site est mis à 0 de façon à bloquer les opérations de mise en phase suivantes sur ce composant. A la fin de l'opération de mise en phase (qu'elle soit trouvée ou non), ou si le site est inhibé, le compteur d'adresse 70 avance d'un pas de façon à pointer la mémoire sur le site suivant. Dans la mémoire principale 10 (ou de sous-programme), il doit y avoir autant d'appel aux opérations de mise en phase qu'il y a de sites (tête 1 et tête 2) : les sites inhibés ayant été dévalidés lors du remplissage de la mémoire). A la fin des opérations de mise en phase, une instruction CLRM ("clear MATCH") permet de remettre le compteur d'adresse 70 à 0.

Prenons l'exemple de la séquence programmée dans la mémoire principale (INC, RPTM, RPTM, CLRM). Supposons que le contenu de la mémoire de validation 46 corresponde au tableau suivant (le bit 0 de la mémoire correspondant à la sortie Valid 72, le bit 1 à la sortie 50 Tête 2, le bit 2 à la sortie 44 Tête 1 et Adr. à l'entrée Adresse 96) :

| Adr | Bit 2 : Tête 1 | Bit 1 : Tête 2 | Bit 0 : Valid | |
|---|---|---|---|---|
| 0 | 1 | 0 | 1 | Mise en phase validée sur la tête 1 (site 0) |
| 1 | 0 | 1 | 1 | Mise en phase validée sur la tête 2 (site 1) |
| 2 | 1 | 0 | 0 | Mise en phase inhibée (composant jugé mauvais lors d'un précédent test) (site 3) |
| 3 | 0 | 1 | 1 | Mise en phase validée sur la tête 2 (site 4) |

Lors du démarrage de la séquence de test, on suppose que le compteur d'adresse 70 est sur 0 ; la mémoire de validation 46 est donc adressée à l'adresse 0.
1) INC : une période de signal est générée, en fonction du contenu de la mémoire principale. Le compteur d'adresse 12 de la mémoire principale 10 est incrémenté pour pointer sur la ligne suivante.
2) RPTM : l'autre instruction s'exécute sur le site 0 car la mémoire est validée. Les événements correspondant à cette ligne de la mémoire principale ne font pas de comparaison sur des broches autres que celles du site 0 de façon à ne pas perturber le résultat (résu 1) qui est utilisé par le circuit de mise en phase 54. En admettant que la mise en phase soit trouvée, le compteur d'adresse 70 s'incrémente de façon à adresser l'adresse 1 de la mémoire de validation 46. Comme la mise en phase est trouvée, le compteur d'adresse 12 de la mémoire principale est incrémenté.
3) RPTM : identique à 2) sur le site 1
4) RPTM : la mémoire de validation 46 inhibe le site ; l'instruction RPTM est transformée en instruction INC ; il n'y a pas eu de temps perdu sur ce composant.
5) RPTM : identique à 2) et 3). Supposons que la mise en phase ne soit pas trouvée. Le bit "dépassement" est activé par le circuit de mise en phase. Ce bit vient écrire dans la mémoire de validation par l'entrée Wr 100. Ainsi, le bit 0 (sortie Valid 72) de l'adresse 3 vaut 0. Les mises en phase qui pourraient avoir lieu dans cette séquence seraient inhibées (cas 4) sur ce site.
6) CLRM : le compteur d'adresse 70 est remis à 0 de façon à commencer sur le site 0 si d'autres séquences de mise en phase interviennent pendant ce test.

La mémoire de validation 46 peut être relue après un test fonctionnel. En relisant cette mémoire et en la comparant à son contenu initial, on peut identifier les sites qui ont échoués en équivalence.

## Revendications

1. Procédé de test en parallèle de composants électroniques en utilisant des instructions (14) contenues dans une mémoire principale (10), ou sous programme, chaque instruction contenant des informations relatives au test à effectuer sur les sites à tester en parallèle après mise en phase des composants selon une séquence de mise en phase destinée à amener chaque composant dans un état connu et identique, ledit procédé étant caractérisé par les étapes suivantes permettant d'éliminer les séquences de mise en phase d'un composant lorsque l'une d'entre elles n'a pas abouti tout en autorisant les mises en phase du ou des autres composants :
- l'adresse du site en cours de test est enregistrée dans un compteur (70),
- des informations de validation selon lesquelles la séquence de mise en phase d'un site doit être effectuée ou ignorée sont contenues dans une mémoire de validation (46) adressée par ledit compteur (70) et,
- lesdites informations de validation sont écrites préalablement à la séquence de test de façon à effectuer la séquence de mise en phase du site en cas de validation ou à ignorer celle ci en passant à l'instruction suivante dans la mémoire principale (10).

2. Procédé selon la revendication 1 caractérisé en ce que ladite mémoire de validation est programmée a priori lorsque les sites à ne pas tester sont connus d'avance.

3. Procédé selon la revendication 1 caractérisé en ce que ladite mémoire de validation est programmée en cours de test lorsque la séquence de mise en phase d'un composant n'aboutit pas, les séquences de mise en phase ultérieures pour ce composant, étant ainsi dévalidées.

4. Procédé selon la revendication 1 caractérisé en ce que les instructions de déroulement de séquence contenues dans la mémoire principale ou la mémoire sous programme sont décodées et validées ou transformées à l'aide de ladite mémoire de validation afin respectivement d'effectuer ou de ne pas effectuer la séquence de mise en phase sur le site défini par ledit compteur.

5. Equipement de test automatique de composants électroniques munis de broches de connexion dans lequel des composants sont testés en parallèle à l'aide d'au moins une tête de test, comprenant:
- une mémoire principale (10), des instructions (14) à exécuter pour le test et une table (18) contenant des données à comparer aux données résultant des tests,
- des circuits élémentaires de test (20), chacun d'eux étant affecté à une broche de connexion et relié aux entrées et sorties de la ou desdites têtes de test, l'entrée des circuits élémentaires étant reliée à la sortie de la mémoire principale (10),
- un circuit de mise en phase (54) pour comparer les données de test à des données prédéterminées, afin d'amener chaque composant dans un état connu et identique selon une séquence de mise en phase. ce circuit étant connecté aux sorties desdits circuits élémentaires de test (20), l'équipement de test étant caractérisé, pour permettre d'éliminer les séquences de mise en phase d'un composant lorsque l'une d'entre elles n'a pas abouti tout en autorisant les mises en phase du ou des autres composants, par :
- un compteur (70) qui détermine les sites à mettre en phase et qui possède une entrée d'incrémentation (88) connectée une sortie (60) dudit circuit de mise en phase et.
- une mémoire de validation (46) adressée par ledit compteur (70) et qui définit si chacun desdits sites doit être mis en phase ou ignoré.

6. Equipement de test selon la revendication 5 caractérisé en ce que ladite mémoire de validation (46) comporte une sortie de validation (72) qui modifie l'instruction qui gère le déroulement de la mémoire principale (10) lorsque la séquence de mise en phase d'un site doit être ignorée.

7. Equipement de test selon la revendication à caractérisé en ce qu'il comporte des moyens de multiplexage (68) reliés à un registre (66) pour la programmation a priori de la mémoire de validation (46) et aux entrées de ladite mémoire de validation pour sa programmation à la volée.

8. Equipement de test selon la revendication 5 et comportant plusieurs têtes de test, caractérisé en ce que ladite mémoire de validation comporte en outre une sortie distincte (44, 50) affectée à chacune desdites têtes.

9. Equipement de test selon la revendication 8 caractérisé en ce qu'il comporte des moyens logiques (32, 34, 40) intercalés entre lesdits circuits élémentaires de test (20) et ledit circuit de mise en phase (54) et reliés aux sorties (44, 50) des têtes, lesdits moyens logiques permettant de valider ou de ne pas considérer une opération de mise en phase sur une ou plusieurs desdites têtes.

10. Equipement de test selon la revendication 6 caractérisé en ce qu'il comporte des moyens de décodage (76) recevant et décodant les instructions de ladite mémoire principale (10) et reliés à ladite sortie de validation (72) de la mémoire de validation (46), une sortie desdits moyens de décodage agissant sur le décodeur d'instructions de gestion de la mémoire principale ou sous programme(12) pour faire réaliser l'opération de mise en phase ou ignorer celle ci.

## Patentansprüche

1. Verfahren zum parallelen Testen elektronischer Komponenten unter Verwendung von Befehlen (14), enthalten in einem Hauptspeicher (10) oder Unterprogrammspeicher, wobei jeder Befehl Informationen bezüglich des auszuführenden Tests an den parallel zu testenden Standorten nach Phasenanpassung der Komponenten gemäß einer Phasenanpaßsequenz enthält, die dazu bestimmt ist, jede Komponente in einen bekannten und identischen Zustand zu bringen, welches Verfahren durch die nachfolgenden Schritte gekennzeichnet ist, welche es erlauben, Phasenanpaßsequenzen einer Komponente zu eliminieren, wenn eine von ihnen nicht eingelaufen ist, unter Zulassung der Phasenanpassung der anderen Komponente(n):
- die Adresse des laufenden Teststandorts wird in einem Zähler (70) registriert,
- Validierungsinformationen, gemäß welchen die Phasenanpaßsequenz eines Standorts auszuführen oder zu ignorieren ist, sind in einem von dem Zähler (70) adressierten Validierungsspeicher (46) enthalten,
- die Validierungsinformationen werden vor der Testsequenz derart eingeschrieben, daß die Phasenanpaßsequenz des Standorts im Falle der Validierung erfolgt oder diese ignoriert wird, indem zum folgenden Befehl in dem Hauptspeicher (10) übergegangen wird.

2. Verfahren nach Anspruch 1, dadurch gekennzeichnet, daß der Validierungsspeicher vorab programmiert wird, wenn die nicht zu testenden Standorte vorab bekannt sind.

3. Verfahren nach Anspruch 1, dadurch gekennzeichnet, daß der Validierungsspeicher während des Testablaufs programmiert wird, wenn die Phasenanpaßsequenz einer Komponente erfolglos ist, so daß die späteren Phasenanpaßsequenzen für diese Komponente devalidiert werden.

4. Verfahren nach Anspruch 1, dadurch gekennzeichnet, daß die Auslaufbefehle der in dem Haupt- oder Unterprogrammspeicher enthaltenen Sequenzen dekodiert und validiert oder mit Hilfe des Validierungsspeichers umgesetzt werden, um an dem von dem Zähler definierten Standort die Phasenanpaßsequenz auszuführen oder nicht.

5. Automatische Testeinrichtung elektronischer Komponenten, versehen mit Anschlüssen, in denen die Komponenten mit Hilfe mindestens eines Testkopfes parallel getestet werden, umfassend:
- einen Hauptspeicher (10) mit für den Test auszuführenden Befehlen (14) und einer Tabelle (18), die mit den Testergebnisdaten zu vergleichende Daten enthält,
- Elementartestschaltkreise (20), von denen jeder einem Anschluß zugeordnet ist und mit den Eingängen und Ausgängen des Testkopfes oder der Testköpfe verbunden ist, wobei der Eingang der Elementarschaltkreise mit dem Ausgang des Hauptspeichers (10) verbunden ist,
- einen Phasenanpaßschaltkreis (54) für das Vergleichen der Testdaten mit vorbestimmten Daten, um jede Komponente gemäß einer Phasenanpaßsequenz in einen bekannten und identischen Zustand zu bringen, welcher Schaltkreis mit den Ausgängen der Elementartestschaltkreise (20) verbunden ist, welche Testeinrichtung, um zu ermöglichen, Phasenanpaßsequenzen einer Komponente, wenn eine von ihnen nicht eingelaufen ist, zu eliminieren, unter Zulassung der Phasenanpassung der anderen Komponente(n), gekennzeichnet ist durch:
- einen Zähler (70), der die in Phase zu bringenden Standorte bestimmt und einen mit einem Ausgang (60) des Phasenanpaßschaltkreises verbundenen Inkrementiereingang (88) aufweist, und
- einen von dem Zähler (70) adressierten Validierungsspeicher (46), der definiert, ob jeder der Standorte in Phase zu bringen oder zu ignorieren ist.

6. Testeinrichtung nach Anspruch 5, dadurch gekennzeichnet, daß der Validierungsspeicher (46) einen Gültigkeitsausgang (72) aufweist, der den Befehl modifiziert, welcher den Auslauf des Hauptspeichers (10) verwaltet, wenn die Phasenanpaßsequenz eines Standortes zu ignorieren ist.

7. Testeinrichtung nach Anspruch 5, dadurch gekennzeichnet, daß sie Multiplexiermittel (68), verbunden mit einem Register (66) für die Vorab-Programmierung des Validierungsspeichers (46), und verbunden mit Eingängen des genannten Speichers für seine fliegende Programmierung umfaßt.

8. Testeinrichtung nach Anspruch 5 mit mehreren Testköpfen, dadurch gekennzeichnet, daß der Validierungsspeicher einen eigenen Ausgang (44, 50), jeweils zugeordnet einem der Köpfe, aufweist.

9. Testeinrichtung nach Anspruch 8, dadurch gekennzeichnet, daß sie Logikmittel (32, 34, 40) umfaßt, eingefügt zwischen den ELementartestschaltkreisen (20) und dem Phasenanpaßschaltkreis (54) und mit den Ausgängen (44, 50) der Köpfe verbunden, welche Logikmittel es ermöglichen, eine Phasenanpaßoperation an einem oder mehreren der Köpfe zu validieren oder außer Betracht zu lassen.

10. Testeinrichtung nach Anspruch 6, dadurch gekennzeichnet, daß sie Dekodiermittel (76) umfaßt, die die Befehle des Hauptspeichers (10) empfangen und dekodieren und mit dem Gültigkeitausgang (72) des Validierungsspeichers (46) verbunden sind, wobei ein Ausgang der Dekodiermittel auf den Befehlsdekoder der Verwaltung des Haupt- oder Unterprogrammspeichers (12) einwirkt, um eine Phasenanpaßoperation auszuführen oder sie zu ignorieren.

## Claims

1. A method of testing electronic components in parallel by using instructions contained in a main memory, or in a sub-program memory, each instruction containing information relating to the test to be performed on the sites to be tested in parallel after the components have been matched using a matching sequence for bringing each component into a known and identical state, said method being characterized by the following steps making it possible to eliminate the matching sequences for matching a component when one of them has not succeeded, while allowing the other component(s) to be matched:
the address of the site under test is recorded in a counter;
enabling information on the basis of which the matching sequence for matching a site must be performed or ignored is contained in an enable memory addressed by said counter; and
said enabling information is written prior to the test sequence so as to perform the matching sequence for matching the site in the event of enabling, or so as to ignore it by going on to the following instruction in the main memory.

2. A method according to claim 1, characterized in that said enable memory is programmed a priori when the sites not to be tested are known in advance.

3. A method according to claim 1, characterized in that said enable memory is programmed during testing when the matching sequence for matching a component has not succeeded, the subsequent matching sequences for this component thus being disabled.

4. A method according to claim 1, characterized in that the sequence-running instructions contained in the main memory or in the sub-program memory are decoded and enabled or transformed by means of said enable memory so as respectively to perform or not to perform the matching sequence on the site defined by said counter.

5. Test equipment for automatically testing electronic components provided with connection pins, in which equipment the components are tested in parallel by means of at least one test head, said equipment comprising:
a main memory (10), instructions (14) to be executed for the test, and a table (18) containing data to be compared with the data resulting from the tests;
elementary test circuits (20), each of which is assigned to a connection pin and is connected to the inputs and outputs of said test heads, the inputs of the elementary circuits being connected to the output of the main memory (10);
a matching circuit (54) for comparing the test data with predetermined data, so as to bring each component into a known and identical state using a matching sequence, the circuit being connected to the outputs of said elementary test circuits (20);
said test equipment being characterized by the following to make it possible to eliminate the matching sequences for matching a component when one of them has not succeeded, while allowing the other component(s) to be matched:
a counter (70) which determines the sites to be matched, and which has an incrementation input (88) connected to an output (60) of said matching circuit; and
an enable memory (46) addressed by said counter (70) and which defines whether each of said sites is to be matched or ignored.

6. Test equipment according to claim 5, characterized in that said enable memory (46) includes an enable output (72) which modifies the instruction that manages running of the main memory (10) when the matching sequence for matching a site must be ignored.

7. Test equipment according to claim 5, characterized in that it includes multiplexing means (68) connected to a register (66) for programming a priori the enable memory (46) and to the inputs of said enable memory for programming it in real time.

8. Test equipment according to claim 5 and including a plurality of test heads, said equipment being characterized in that said enable memory further includes a distinct output (44, 50) assigned to each of said heads.

9. Test equipment according to claim 8, characterized in that it includes logic means (32, 34, 40) interposed between said elementary test circuits (20) and said matching circuit (54) and connected to the outputs (44, 50) of the heads, said logic means making it possible to enable or to ignore a matching operation on one or more of said heads.

10. Test equipment according to claim 6, characterized in that it includes decoding means (76) receiving and decoding the instructions from said main memory (10) and connected to said enable output (72) of the enable memory (46), an output of said decoding means acting on the decoder of the instructions for managing the main memory or the sub-program memory (12) to cause the matching operation to be performed or to be ignored.
